# FASCICULE DE BREVET EUROPEEN

(11) **EP 2 782 868 B1**
(45) Date de publication et mention de la délivrance du brevet: **14.03.2018**
(21) Numéro de dépôt: 12775690.6
(22) Date de dépôt: 23.10.2012
(51) Int. Cl.: B81C 1/00

(54) **PROCÉDÉ DE FABRICATION D'UN DISPOSITIF D'ENCAPSULAGE**
HERSTELLUNGSVERFAHREN EINER VORRICHTUNG ZUR VERKAPSELUNG
METHOD FOR MANUFACTURING AN ENCAPSULATION DEVICE

(30) Priorité: 23.11.2011 EP 11190264
(43) Date de publication de la demande: 01.10.2014
(73) Titulaire: Micro Crystal AG, 2540 Grenchen (CH)
(72) Inventeur: DEILLON, Léa, 1722 Bouguillon (CH); DALLA PIAZZA, Silvio, 2610 St-Imier (CH); HESSLER, Thierry, 2024 St-Aubin (CH)
(74) Mandataire: Goulette, Ludivine
(86) Numéro de dépôt international: PCT/EP2012/070972
(87) Numéro de publication internationale: WO 2013/075901

(56) Documents cités:
- US-A1- 2011 266 030
- WANG P J ET AL: "Fluxless Wafer-to-Wafer Bonding in Vacuum Using Electroplated Sn-Rich Sn-Ag Dual-layer Structure", ELECTRONIC COMPONENTS AND TECHNOLOGY CONFERENCE 2006, 56TH SAN DIEGO, CA MAY 30 - JUNE 2, 2006, PISCATAWAY, NJ, USA,IEEE, 30 mai 2006 (2006-05-30), pages 1290-1293, XP010923549, DOI: 10.1109/ECTC.2006.1645820 ISBN: 978-1-4244-0152-9
- SUNG-HOON CHOA: "Reliability study of hermetic wafer level MEMS packaging with through-wafer interconnect", MICROSYSTEM TECHNOLOGIES ; MICRO AND NANOSYSTEMS INFORMATION STORAGE AND PROCESSING SYSTEMS, SPRINGER, BERLIN, DE, vol. 15, no. 5, 7 février 2009 (2009-02-07), pages 677-686, XP019719726, ISSN: 1432-1858
- WON KYOUNG CHOI ET AL: "Development of low temperature bonding using in-based solders", 58TH ELECTRONIC COMPONENTS AND TECHNOLOGY CONFERENCE - 27-30 MAY 2008 20080527 IEEE, PISCATAWAY, NJ, USA, 27 mai 2008 (2008-05-27), pages 1294-1299, XP031276362, ISBN: 978-1-4244-2230-2
- YOON ET AL: "Investigation of interfacial reaction between Au-Sn solder and Kovar for hermetic sealing application", MICROELECTRONIC ENGINEERING, ELSEVIER PUBLISHERS BV., AMSTERDAM, NL, vol. 84, no. 11, 25 septembre 2007 (2007-09-25), pages 2634-2639, XP022266651, ISSN: 0167-9317, DOI: 10.1016/J.MEE.2007.05.058

## Description

### Domaine de l'invention

L'invention se rapporte à un procédé de fabrication d'un dispositif d'encapsulage pour un système électro-micromécanique (également connu sous l'abréviation MEMS provenant des termes anglais « Micro Electro Mechanical System ») et, notamment, pour un MEMS du type résonateur à quartz.

### Arrière plan de l'invention

Les composants électroniques ayant un MEMS sont formés généralement par un boîtier hermétiquement fermé dans lequel est monté le MEMS. Le MEMS peut être par exemple un résonateur piézoélectrique, tel qu'un résonateur à quartz destiné à être relié à un circuit oscillateur. La plupart des résonateurs à quartz de petites dimensions, qui sont utilisés par exemple dans les montres électroniques ou électromécaniques, sont des résonateurs du type diapason.

De tels résonateurs à quartz sont habituellement enfermés sous vide dans des boîtiers, dans le cas de la génération de signaux basse fréquence fournis par le circuit oscillateur, ou sous atmosphère de gaz inerte. De plus, une partie du couvercle peut être transparente à une longueur d'onde déterminée d'un faisceau de lumière afin de permettre le réglage optique du résonateur à quartz.

Généralement, de tels résonateurs sont montés dans des boîtiers par exemple en céramique qui sont relativement plats. Ces boîtiers comprennent une partie principale creuse de forme parallélépipédique à l'intérieur de laquelle est monté le résonateur, et un couvercle rectangulaire fixé sur la partie principale.

Afin d'assurer l'étanchéité entre le couvercle et la partie principale, actuellement, on utilise un joint en alliage métallique eutectique à base d'or et d'étain qui est rapporté entre les deux parties puis l'ensemble est chauffé afin de sceller définitivement le boîtier sous atmosphère contrôlée.

Ces alliages à base d'or et d'étain présentent les inconvénients d'utiliser des matériaux intrinsèquement chers et de posséder un point de fusion relativement bas, c'est-à-dire autour de 278°C. Cette dernière caractéristique limite les procédés possibles lors de ou après la connexion du boîtier sur son support d'utilisation comme un circuit imprimé, par exemple. On comprend en effet qu'aucun traitement thermique supérieur à 280°C réalisé ultérieurement à la connexion n'est possible sous risque de descellement du boîtier qui, même partiel, ferait perdre l'herméticité du dispositif et donc les performances du résonateur.

### Résumé de l'invention

Le but de la présente invention est de pallier tout ou partie les inconvénients cités précédemment en proposant un nouveau type de dispositif d'encapsulage hermétique et son procédé de fabrication.

L'invention se rapporte ainsi à un procédé de fabrication d'un dispositif d'encapsulage selon la revendication 1 et à un composant selon la revendication 14.

Avantageusement selon l'invention, ladite au moins une couche de métal est protégée par le (ou les) intermétallique(s) qui forme une barrière de protection. De plus, il reste du matériau dont le point de fusion est inférieur à 250°C pour la future formation des moyens d'étanchéité.

En outre, le matériau dont le point de fusion est inférieur à 250°C qui est déposé est un matériau pur et non un alliage eutectique à base d'or pour la future formation des moyens d'étanchéité.

A partir des boîtiers actuels dont les métallisations comportent déjà du nickel, on comprend donc que seul le matériau à bas point de fusion est nécessaire d'être rapporté pour effectuer l'herméticité du boîtier. De plus, la base en nickel est sensiblement moins chère que celle en or et permet en outre d'obtenir au moins un intermétallique dont le point de fusion est situé à une température plus élevée que les moyens d'étanchéité actuels et donc compatible avec les températures utilisées dans les procédés standard de montage du dispositif, sans risque de perte d'herméticité.

En outre, par rapport aux moyens d'étanchéité actuels, il est apparu que le (ou les) deuxième(s) intermétallique(s) formé(s) à partir du nickel a des cinétiques de croissance plus lentes ce qui permet avantageusement de mieux contrôler leur formation. Enfin, le (ou les) deuxième(s) intermétallique(s) est formé uniquement à partir de ladite au moins une couche de nickel de la partie principale grâce au(x) premier(s) intermétallique(s) qui bloque toute autre diffusion.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une vue de dessus du composant électronique selon l'invention ;
- la figure 2 est une vue selon la coupe A-A de la figure 1 du composant électronique selon l'invention ;
- les figures 3 et 4 sont des vues agrandies localisées sur le couvercle avant et après la première diffusion selon l'invention ;
- la figure 5 est une vue agrandie localisée sur la partie principale avant la deuxième diffusion selon l'invention ;
- la figure 6 est une vue agrandie localisée sur l'interface entre la partie principale et le couvercle après la deuxième diffusion selon l'invention ;
- la figure 7 est un schéma fonctionnel du procédé de fabrication selon l'invention
- la figure 8 est une vue en coupe d'un exemple de moyens d'étanchéité obtenus selon l'invention ;
- la figure 9 est une vue partielle et agrandie de la figure 8 ;
- les figures 10 et 11 sont des vues agrandies localisées sur une première variante de couvercle avant et après la première diffusion selon l'invention ;
- les figures 12 et 13 sont des vues agrandies localisées sur une deuxième variante de couvercle avant et après la première diffusion selon l'invention.

### Description détaillée des modes de réalisation préférés

Dans la description suivante, toutes les parties du composant qui sont bien connues d'un homme du métier dans ce domaine technique, ne seront pas expliquées en détail.

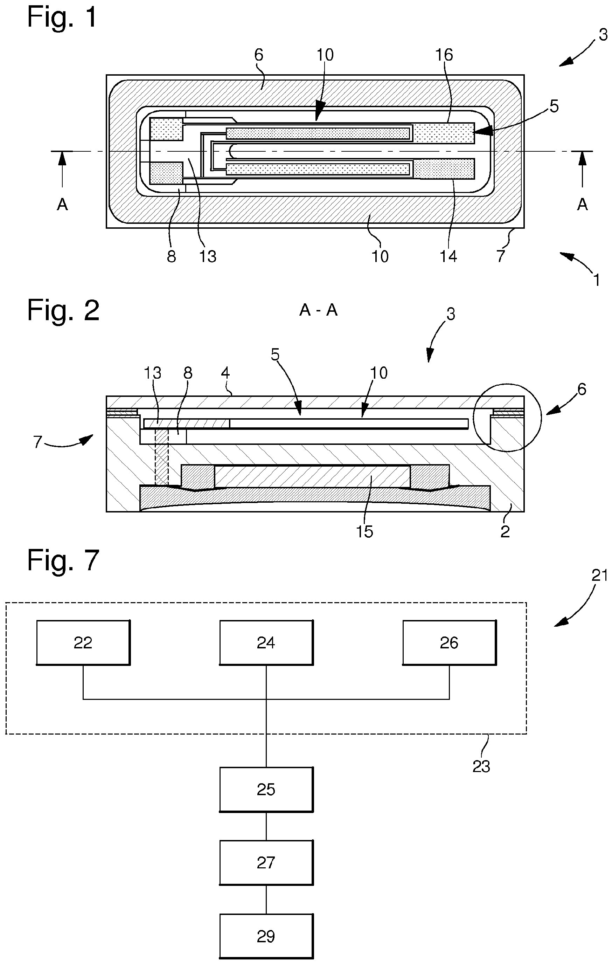

Le composant électronique 1 est représenté de manière simplifiée aux figures 1 et 2. Il comporte principalement un dispositif d'encapsulage 3 destiné à recevoir un MEMS 5 de manière hermétique. Le dispositif d'encapsulage 3 comprend un boîtier 7 formé par une partie principale creuse 2 et un couvercle 4 destiné à fermer la partie creuse 2 à l'aide de moyens d'étanchéité 6.

Dans l'exemple illustré aux figures 1 et 2, le MEMS 5 représenté est un résonateur diapason à quartz, cependant d'autres types de MEMS 5 nécessitant un encapsulage sous vide ou sous atmosphère contrôlée sont également applicables.

La partie creuse 2 est généralement de forme parallélépipédique et comporte une portée 8 dans la cavité 10 intérieure destinée à fixer le MEMS 5 en porte-à-faux. Les extrémités libres des parois entourant la cavité 10 sont destinées à recevoir le couvercle 4 de forme sensiblement rectangulaire à l'aide des moyens d'étanchéité 6 afin d'enfermer de manière hermétique le MEMS 5 dans le dispositif d'encapsulage 3.

A titre d'exemple, le boîtier 7, c'est-à-dire la partie creuse 2 et le couvercle 4, peut être de 5 mm de long, 3,2 mm de large et 1,08 mm de haut. De plus, le boîtier 7 est de préférence réalisé en céramique selon une technique habituelle.

Les moyens d'étanchéité 6 sont formés par une succession de couches destinées à adhérer à la céramique et à former la couche autorisant l'herméticité. Avantageusement selon l'invention, les moyens d'étanchéité 6 comportent un alliage à base de nickel associé à un matériau dont le point de fusion est bas, c'est-à-dire très inférieur à celui du nickel comme par exemple de l'ordre de 250°C maximum. De manière préférée, le matériau utilisé peut être de l'indium ou de l'étain.

Ces alliages In-Ni ou Ni-Sn, qui peuvent comporter plusieurs intermétalliques, sont obtenus par une soudure faisant intervenir une interdiffusion solide-liquide, c'est-à-dire que la différence de point de fusion entre l'indium ou l'étain par rapport à celui de nickel permet de fondre un de ces premiers matériaux et de le faire diffuser dans la couche de nickel solide afin de former des intermétalliques.

Ces soudures peuvent ainsi être réalisées à « basse » température, c'est-à-dire en dessous de 250°C tout en acceptant des traitements thermiques postérieurs à des températures bien supérieures induites par les points de fusion des intermétalliques obtenus, c'est-à-dire compris entre 400°C et 800°C.

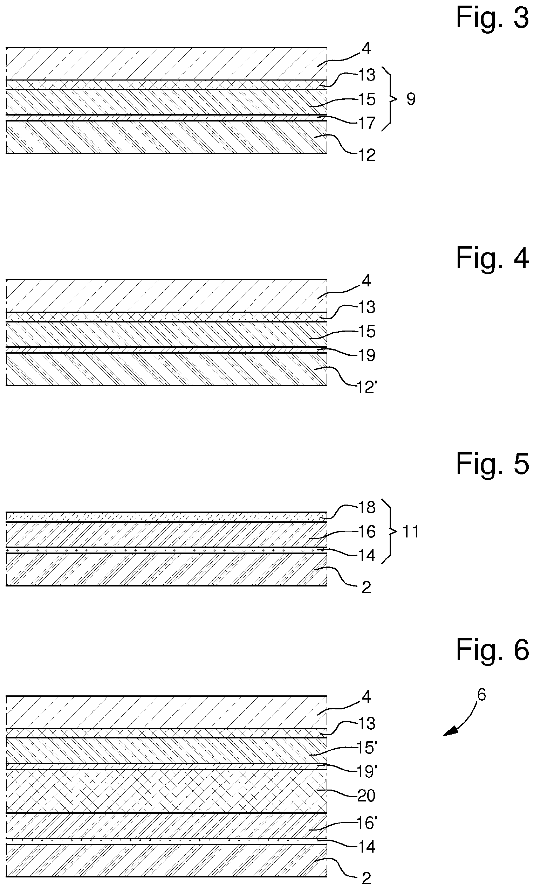

Avantageusement selon l'invention, les boîtiers céramiques 7 commercialisés actuellement comportent des métallisations 9, 11 qui comprennent déjà au moins une couche de nickel comme visible aux figures 3 et 5.

Typiquement comme visible à la figure 3, la métallisation 9 du couvercle 4 comporte plusieurs couches. Une première couche optionnelle d'accrochage 13 formée avec, par exemple, du molybdène ou du tungstène et au moins une couche de métal 15 comme du nickel. La métallisation 9 peut également comporter un revêtement 17 de protection contre l'oxydation par exemple en or. Les couches d'accrochage 13 et de métal 15 ont des épaisseurs respectivement de 10 µm et de 5 µm tandis que le revêtement 17 de protection est d'environ 0,75 µm.

De manière similaire comme visible à la figure 5, la métallisation 11 de la partie principale 2 comporte également plusieurs couches. Une première couche optionnelle d'adhérence 14 formée avec, par exemple, du molybdène ou du tungstène et au moins une couche de métal 16 comme du nickel. La métallisation 11 peut également comporter une couche 18 de protection contre l'oxydation par exemple en or. Les couches d'adhérence 14 et de métal 16 ont des épaisseurs respectivement de 10 µm et de 5 µm tandis que celle 18 de protection est d'environ 0,75 µm.

Dès lors, on comprend que, pour former les moyens d'étanchéité 6 en un intermétallique indium-nickel ou nickel-étain, une seule couche 12 d'indium pur ou d'étain pur est nécessaire pour réaliser la soudure par interdiffusion solide-liquide selon l'invention.

Par conséquent, le MEMS 5 peut, à l'aide des moyens d'étanchéité 6, être enfermé sous vide ou sous atmosphère contrôlée dans la cavité 10 du dispositif d'encapsulage 3 avec des matériaux moins coûteux et en obtenant au moins un intermétallique dont le point de fusion est situé à une température plus élevée que les moyens d'étanchéité actuels.

Dans l'exemple illustré aux figures 1 et 2, le MEMS 5 est un diapason en quartz classique constitué de deux branches 14, 16 parallèles pour vibrer en mode de flexion dont la base commune 13 est fixée sur la portée 8. Les couches de métallisation du MEMS 5 nécessaires à l'actionnement piézoélectrique ainsi que les plages de connexion à un circuit intégré 15 ayant, par exemple, un étage oscillateur ne sont pas présentés en détail car ces éléments ne sont pas déterminants pour l'application de l'invention.

Le procédé 21 de fabrication du dispositif d'encapsulage 3 va maintenant être expliqué en référence aux figures 3 à 7. Le procédé 21 comporte une première étape 23 destinée à fabriquer, de manière indépendante, lors de phases 22, 24 et 26, respectivement le MEMS 5, le couvercle 4 et la partie creuse 2.

Ainsi, si le MEMS 5 est un résonateur diapason en quartz, la phase 22 peut consister à graver, dans un monocristal de quartz, une plaquette, puis graver le corps du diapason dans l'épaisseur de cette plaquette pour enfin instrumenter le diapason, c'est-à-dire déposer les couches électriquement conductrices nécessaires à son fonctionnement.

Le couvercle 4 est préférentiellement formé l'aide d'une céramique lors de la phase 24. Pour ce faire, de manière habituelle, une ou plusieurs feuilles de céramique sont ouvragées, empilées et fixées les unes sur les autres. Ensuite, le couvercle 4 est partiellement métallisé pour permettre la future coopération avec la partie principale 2. Selon l'invention, après la formation du couvercle 4, on dépose donc au moins une couche 15 de métal protégé par un revêtement 17. Le couvercle 4 comporte ainsi plusieurs couches de métaux. Une première couche optionnelle d'accrochage 13 formée avec, par exemple, du molybdène et/ou du tungstène et/ou du titane et/ou du chrome et au moins une couche de métal 15 comme du nickel.

Les couches d'accrochage 13 et de métal 15 peuvent avoir des épaisseurs de respectivement 10 µm et de 5 µm tandis que le revêtement 17 de protection est d'environ 0,75 µm.

La partie principale 2 est préférentiellement formée l'aide d'une céramique lors de la phase 26. Pour ce faire, de manière habituelle, plusieurs feuilles de céramique sont ouvragées, empilées et fixées les unes sur les autres. Ensuite, la partie principale 2 est partiellement métallisée pour permettre la future coopération avec le couvercle 4.

Selon l'invention, après la formation de la partie principale 2, on dépose donc au moins une couche de métal 16 comme du nickel éventuellement protégé par un revêtement 18 qui peut par exemple être en or. De plus, préalablement au dépôt de couche 16 par exemple en nickel, une étape intermédiaire destinée à déposer une couche d'adhérence 14 pour la couche 16 peut être réalisée.

Comme expliqué ci-dessus, la partie principale 2 comporte ainsi plusieurs couches de métaux. Une première couche optionnelle d'adhérence 14 formée avec, par exemple, du molybdène et/ou du tungstène et/ou du titane et/ou du chrome et au moins une couche de métal 16. La couche 16 peut comporter un revêtement 18 de protection contre l'oxydation par exemple en or comme illustré à la figure 5.

Les couches d'adhérence 14 et de nickel 16 peuvent avoir des épaisseurs de respectivement 10 µm et de 5 µm tandis que le revêtement 18 de protection optionnel est d'environ 0,75 µm. Ces dépôts peuvent être réalisés, par exemple, par sérigraphie, galvanoplastie ou dépôt physique en phase vapeur.

Avantageusement selon l'invention, la phase 24 ou la phase 26 du procédé 21 se poursuit avec une étape destinée à déposer une couche 12 d'un matériau dont le point de fusion est inférieur à 250°C sur le revêtement 17, 18 par exemple formé en or du couvercle 4 ou de la pièce principale 2. Comme expliqué ci-dessus, le matériau dont le point de fusion est inférieur à 250°C peut être de l'indium ou de l'étain. Une représentation dans laquelle la couche 12 est déposée sur le couvercle 4 est visible à la figure 3.

L'épaisseur de la couche 12 est importante car, dans un premier temps, elle est utilisée pour former un premier intermétallique avec une des couches de protection 17, 18 et, dans un deuxième temps, elle est utilisée pour former un deuxième intermétallique avec au moins une des couches de la métallisation 11, 9 de la partie principale 2 ou du couvercle 4 comme expliqué ci-dessous.

Ainsi, la phase 24 ou 26 se termine par une étape destinée à diffuser partiellement le matériau dont le point de fusion est inférieur à 250°C dans le revêtement 17, 18 afin d'entièrement transformer le revêtement 17, 18 en un intermétallique apte à former une couche 19 de protection de ladite au moins une couche 15 de métal. Une représentation dans laquelle la couche 19 est formée sur le couvercle 4 est visible à la figure 4.

On comprend donc qu'une partie de la couche 12 est utilisée et qu'à la fin de la phase 24 ou 26, la couche 12 devient la couche 12' moins épaisse mais toujours de même nature. Avantageusement selon l'invention, l'étape de diffusion peut être réalisée à température ambiante, il est toutefois possible de l'accélérer en chauffant l'ensemble.

L'épaisseur de ladite au moins une couche 15, 16 de métal utilisée pour la diffusion finale est également importante car elle est utilisée pour « consommer » entièrement la couche 12' en formant un deuxième intermétallique destiné à fermer hermétiquement le boîtier 7. La nature de l'autre au moins une couche 16, 15 de métal présente lors de la première diffusion a moins d'importance en ce qu'elle va peu ou pas interagir.

A la fin de l'étape 24 ou 26, on comprend que ladite au moins une couche 15, 16 comporte un revêtement 19 de protection contre l'oxydation par exemple en alliage or-indium ou or-étain et la couche 12' qui est le reste non diffusé de la couche 12 en indium ou en étain comme illustré à la figure 4. La couche 12 peut comporter une épaisseur comprise entre 15 et 60 µm.

Après diffusion, les couches 13, 14 et 15, 16 restent inchangées. Par contre, on obtient une couche 19 de protection de l'ordre de 5 µm et une couche 12' comprise entre 13,5 et 58,5 µm. Ces dépôts peuvent être réalisés, par exemple, par sérigraphie, galvanoplastie ou dépôt physique en phase vapeur.

Dans une deuxième étape 25, le MEMS 5 est monté dans la cavité 10 de la partie creuse 2 puis, lors de la troisième étape 27, le boîtier 7 est assemblé en mettant en vis-à-vis les couches métalliques afin de les mettre en contact. Enfin, le procédé 21 comporte une dernière étape 29 consistant à souder les couches métalliques pour former les moyens d'étanchéité 6 et ainsi définitivement sceller le dispositif d'encapsulage 3. Comme expliqué ci-avant, suivant le MEMS 5 à encapsuler, l'étape 29 et, éventuellement, l'étape 27 est (sont) réalisée(s) sous vide ou sous atmosphère contrôlée.

L'étape 29 est destinée à diffuser totalement le reste 12' du matériau dont le point de fusion est inférieur à 250°C dans ladite au moins une couche 15, 16 lui faisant face afin d'entièrement transformer le matériau dont le point de fusion est inférieur à 250°C en un deuxième intermétallique 20 apte à fermer hermétiquement ledit composant dans le dispositif d'encapsulage 3 même pour des températures comprises entre 400 et 800°C. L'étape 29 peut consister à presser le couvercle 4 contre le la partie creuse 2 tout en liquéfiant par chauffage la couche 12'.

On comprend donc que la couche 12' est totalement « consommée » par les couches 16 et/ou 15 en formant une couche 20 d'un deuxième intermétallique par exemple à base d'indium-nickel ou de nickel-étain. Toutefois, il subsiste des couches 16' et/ou 15' qui sont le reste non diffusé de la couche 16 et/ou 15 comme illustré à la figure 6.

Par conséquent, après diffusion, il reste les couches 15' et 16' de métal comme par exemple du nickel et, éventuellement, les couches 13 et 14 qui restent inchangées. Dans le cas où une couche 18 de protection est utilisée, elle migrerait en épaississant la couche 19 qui deviendrait 19' comme illustré à la figure 6.

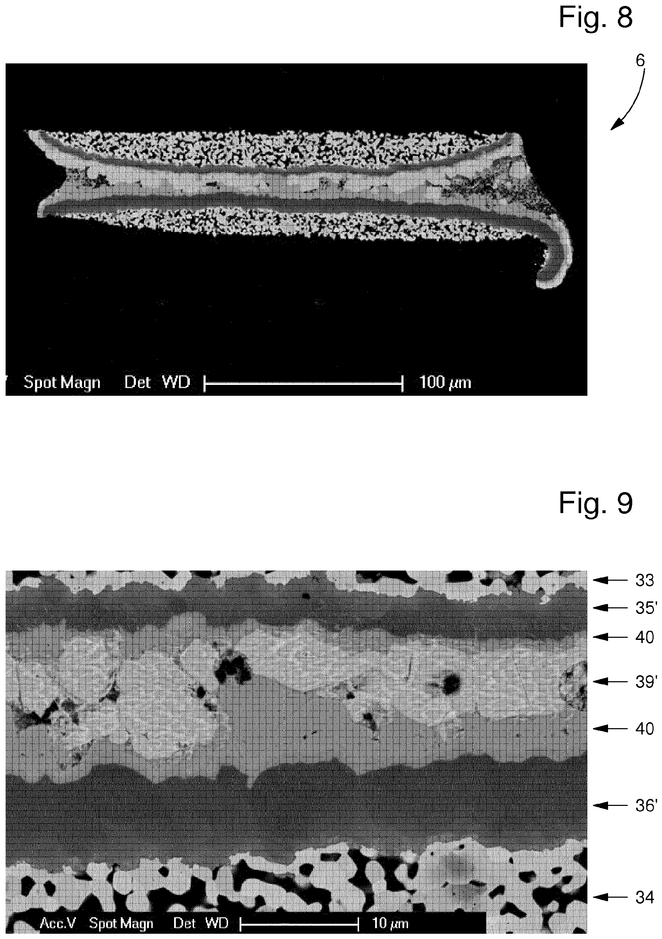

Un autre exemple de moyens d'étanchéité 6 obtenu selon l'invention est présenté aux figures 8 et 9. Dans cette variante, le matériau dont le point de fusion est inférieur à 250°C est de l'indium, les couches de protection de l'or et lesdites couches de métaux du nickel-cobalt. Comme visible aux figures 8 et 9, on obtient du haut vers le bas, une couche 33 d'accrochage (W), une première couche 35' de métal (NiCo), une première couche 40 d'intermétallique (InNiAu), une couche d'intermétallique 39' (AuIn₂), une deuxième couche 40 d'intermétallique (InNiAu), une couche 36' (NiCo) et une couche 34 d'adhérence (W). Avantageusement selon l'invention, le couvercle 4 peut être indifféremment au-dessus de la couche 33 ou en dessous de la couche 34.

On comprend également au vu de l'exemple de la figure 9 par rapport à celui de la figure 6 que les deux au moins une couche de métal peuvent interagir l'une et l'autre pour former deux intermétalliques 40 entourant l'intermétallique 39' formé lors de la phase 24 ou 26 sans sortir du cadre de l'invention.

Avantageusement selon l'invention, par rapport aux moyens d'étanchéité actuels, il est apparu que les intermétalliques formés à partir du nickel en plus de leur coût inférieur ont des cinétiques de croissance plus lentes ce qui permet avantageusement de mieux contrôler leur formation.

A titre optionnel, si le MEMS 5 est un résonateur diapason en quartz, il peut être nécessaire de l'ajuster ou de le régler. Ce réglage peut être effectué après l'étape 25 ou après l'étape 29. Dans ce dernier cas, c'est-à-dire quand le couvercle 4 a déjà fermé hermétiquement la partie creuse 2 du boîtier 7 sous vide, le couvercle 4 devra comprendre au moins une portion transparente à une longueur d'onde déterminée d'un faisceau de lumière, tel qu'un faisceau laser, utilisé pour réaliser ledit réglage.

A l'aide du présent procédé 21, le composant électronique 1 formé est ainsi configuré comme un composant de type SMD (abréviation des termes anglaise « Surface Mounting Device »). A ce titre, il peut être monté et connecté par brasage par exemple sur une plaque de circuit imprimé.

Bien entendu, la présente invention ne se limite pas à l'exemple illustré mais est susceptible de diverses variantes et modifications qui apparaîtront à l'homme de l'art. En particulier, le composant électronique 1 peut ne comprendre que l'élément résonateur 5 ou, à titre alternatif, le procédé 21 pourrait être adapté pour réaliser un processus du type « wafer level packaging » c'est-à-dire un encapsulage en série à partir de deux plaquettes l'une contre l'autre qui sont postérieurement découpées pour former le composant électronique 1.

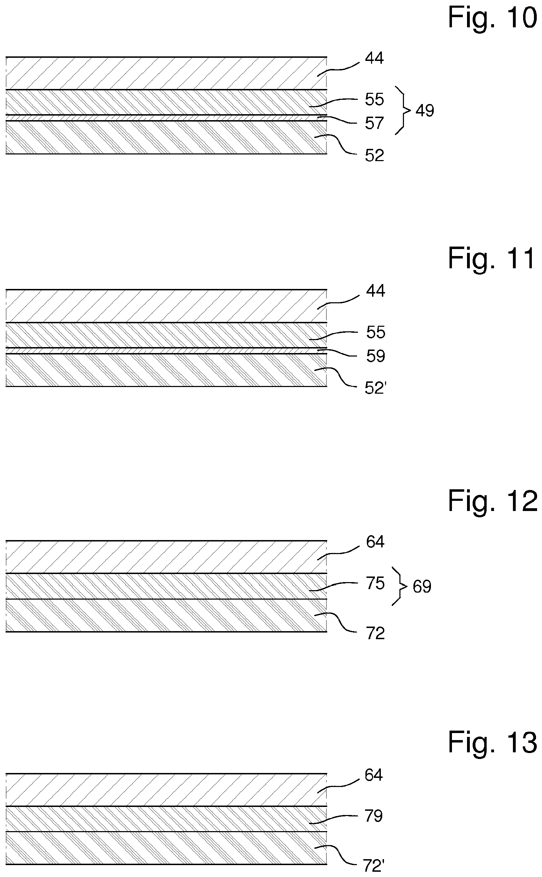

De plus, le couvercle et/ou la pièce principale peuvent être en métal et non en céramique. A titre d'exemple, les figures 10 à 13 présentent deux variantes avec un couvercle 44, 64 en métal. Typiquement, les métallisations 49, 69 enrobent totalement le couvercle et/ou la pièce principale lorsqu'ils sont en métal. On comprend toutefois que l'enrobage peut également être partiel sans effet négatif sur les moyens d'étanchéité 6.

Dans une première variante visible aux figures 10 et 11, le couvercle 44 en métal comme par exemple à base de kovar comporte une métallisation 49 à plusieurs couches. La métallisation 49 comporte au moins une couche de métal 55 comme du nickel ou du cuivre. La métallisation 49 peut également comporte un revêtement 57 de protection contre l'oxydation par exemple en or. La couche de métal 55 a une épaisseur de sensiblement 5 µm tandis que le revêtement 57 de protection est d'environ 0,1 µm.

Avantageusement selon l'invention, une couche 52 d'un matériau dont le point de fusion est inférieur à 250°C est déposée sur le revêtement 57 par exemple formé en or. Comme expliqué ci-dessus, le matériau dont le point de fusion est inférieur à 250°C peut être de l'indium ou de l'étain. Une représentation dans laquelle la couche 52 est déposée sur le couvercle 44 est visible à la figure 10.

L'épaisseur de la couche 52 est importante car, dans un premier temps, elle est utilisée pour former un premier intermétallique avec une des couches de protection et, dans un deuxième temps, elle est utilisée pour former un deuxième intermétallique avec au moins une des couches de la métallisation de la partie principale ou du couvercle comme expliqué ci-dessous.

Ainsi, après l'étape de diffusion destinée à diffuser partiellement le matériau dont le point de fusion est inférieur à 250°C dans le revêtement 57 afin d'entièrement transformer le revêtement 57 en un intermétallique apte à former une couche 59 de protection de ladite au moins une couche 55 de métal. Une représentation dans laquelle la couche 59 est formée sur le couvercle 44 est visible à la figure 11.

On comprend donc qu'une partie de la couche 52 est utilisée et qu'à la fin de la phase 24 ou 26, la couche 52 devient la couche 52' moins épaisse mais toujours de même nature. A la fin de l'étape 24 ou 26, on comprend que ladite au moins une couche 55 comporte un revêtement 59 de protection contre l'oxydation par exemple en alliage or-indium ou or-étain et la couche 52' qui est le reste non diffusé de la couche 52 en indium ou en étain comme illustré à la figure 11. La couche 52 peut comporter une épaisseur comprise entre 15 et 60 µm et s'étendre sur toute ou partie du couvercle 44 et/ou tout ou partie de la métallisation 49.

Après diffusion, la couche 55 reste inchangée. Par contre, on obtient une couche 59 de protection de l'ordre de 5 µm et une couche 52' comprise entre 13,5 et 58,5 µm. Ces dépôts peuvent être réalisés, par exemple, par sérigraphie, galvanoplastie ou dépôt physique en phase vapeur.

Dans une deuxième variante visible aux figures 12 et 13, le couvercle 64 en métal comme par exemple à base de nickel ou de cuivre comporte une métallisation 69 à une seule couche. On comprend donc que le couvercle 64 forme une partie de la métallisation par rapport aux explications précédentes. La métallisation 69 comporte ainsi au moins une couche de métal 75 comme de l'or. La métallisation 69 forme donc toujours un revêtement de protection contre l'oxydation du couvercle 64. La couche de métal 75 a une épaisseur d'environ 0,1 µm.

Avantageusement selon l'invention, une couche 72 d'un matériau dont le point de fusion est inférieur à 250°C est déposée sur la couche 75 par exemple formé en or. Comme expliqué ci-dessus, le matériau dont le point de fusion est inférieur à 250°C peut être de l'indium ou de l'étain. Une représentation dans laquelle la couche 72 est déposée sur le couvercle 64 est visible à la figure 12.

L'épaisseur de la couche 72 est importante car, dans un premier temps, elle est utilisée pour former un premier intermétallique avec le couvercle 64 et, dans un deuxième temps, elle est utilisée pour former un deuxième intermétallique avec au moins une des couches de la métallisation de la partie principale comme expliqué ci-dessous.

Ainsi, après l'étape de diffusion destinée à diffuser partiellement le matériau dont le point de fusion est inférieur à 250°C dans la couche 75 afin d'entièrement transformer le revêtement 75 en un intermétallique apte à former une couche 79 de protection de ladite au moins une couche 55 de métal. Une représentation dans laquelle la couche 79 est formée sur le couvercle 64 est visible à la figure 13.

On comprend donc qu'une partie de la couche 72 est utilisée et qu'à la fin de la phase 24 ou 26, la couche 72 devient la couche 72' moins épaisse mais toujours de même nature. A la fin de l'étape 24 ou 26, on comprend que le couvercle 64 comporte une couche 79 de protection contre l'oxydation par exemple en alliage or-indium ou or-étain et la couche 72' qui est le reste non diffusé de la couche 72 en indium ou en étain comme illustré à la figure 13. La couche 72 peut comporter une épaisseur comprise entre 15 et 60 µm et s'étendre sur toute ou partie du couvercle 64 et/ou tout ou partie de la métallisation 69.

Après diffusion, le corps du couvercle 64 reste inchangé. Par contre, on obtient une couche 79 de protection de l'ordre de 5 µm et une couche 72' comprise entre 13,5 et 58,5 µm. Ces dépôts peuvent être réalisés, par exemple, par sérigraphie, galvanoplastie ou dépôt physique en phase vapeur.

Il peut également être envisagé de monter le circuit oscillateur dans la même cavité 10 que le résonateur 5 à quartz. Ce circuit oscillateur peut comprendre également une fonction d'horloge à temps réel (RTC) ou d'autres fonctions.

Il peut être envisagé également de monter un ou plusieurs MEMS 5 dans chaque boîtier 7 ou encore d'utiliser des matériaux alternatifs pour les boîtiers 7 comme du métal ou du verre, sans sortir du cadre de l'invention. De même, la forme des métallisations 9, 11 ne saurait se limiter à celle des figures 1 et 2.

Il est également possible que les phases 22, 24 et 26 ne soient pas totalement indépendantes en fonction de la technologie du MEMS employée. Il est ainsi envisageable que la phase 26 consistant à former la partie creuse 2 soit réalisée avant la phase 22 de formation du MEMS 5 dans le cas où ce dernier 5 est gravé directement dans cette première 2.

Enfin, un matériau du type « getter » peut être disposé dans le dispositif d'encapsulage 3 pour servir de pompe à vide, c'est-à-dire parfaire le vide dans le dispositif 3 déjà fabriqué, lorsqu'il est activé par exemple au moyen d'un laser ou durant le processus thermique de scellement/diffusion, simplement à l'aide de la température et du temps.

## Revendications

1. Procédé (21) de fabrication d'un dispositif d'encapsulage (3) d'un système électro-micromécanique (5) **caractérisé en ce qu'**il comporte les étapes suivantes :
a) former le système électro-micromécanique (5), une partie principale (2) formant une cavité (10) et un couvercle (4, 44) ;
b) déposer, sur la partie principale (2) et le couvercle (4, 44), respectivement une première et une deuxième métallisations (9, 11, 49) comportant respectivement au moins un premier métal (13, 14, 15, 16, 35, 55) protégé par un premier matériau (18, 19, 57) de protection à l'oxydation, et au moins un deuxième métal (13, 14, 15, 16, 35, 55) protégé par un deuxième matériau (18, 19, 57) de protection à l'oxydation ;
c) déposer une couche (12, 52, 72) d'un matériau (12, 52) dont le point de fusion est inférieur à 250°C sur uniquement l'une des première et deuxième métallisations (9, 11, 49) ;
d) diffuser partiellement le matériau (12, 52) dont le point de fusion est inférieur à 250°C dans uniquement un des premier et deuxième matériaux (18, 19, 57) de protection à l'oxydation afin d'entièrement transformer ledit un des premier et deuxième matériaux (18, 19, 57) de protection à l'oxydation en un intermétallique (19) formé dudit un des premier et deuxième matériaux (18, 19, 57) de protection à l'oxydation et dudit matériau dont le point de fusion est Inférieur à 250°C dans le but de protéger l'un des au moins un premier et au moins un deuxième métaux (13, 14, 15, 16, 35, 55), et de laisser une partie (12', 52') non diffusée du matériau dont le point de fusion est inférieur à 250°C ;
e) monter (25) le système électro-micromécanique (5) dans la cavité (10) de la partie principale (2) ;
f) assembler (27) la partie (12', 52') non diffusée lors de l'étape d) du matériau dont le point de fusion est inférieur à 250°C contre l'autre des première et deuxième métallisations (9, 11, 49) ;
g) diffuser (29) totalement la partie (12', 52') non diffusée lors de l'étape d) du matériau dont le point de fusion est inférieur à 250°C dans l'autre des première et deuxième métallisations (9, 11, 49) afin d'entièrement transformer la partie (12', 52') non diffusée lors de l'étape d) du matériau dont le point de fusion est inférieur à 250°C en un deuxième intermétallique (20) formé par l'autre des premier et deuxième matériaux (18, 19, 57) de protection à l'oxydation, le matériau (12, 52) dont le point de fusion est Inférieur à 250°C et l'autre des au moins un premier et au moins un deuxième métaux (13, 14, 15, 16, 35, 55) de manière à fermer hermétiquement le système électro-micromécanique (5) dans le dispositif d'encapsulage (3).

2. Procédé (21) selon la revendication précédente, **caractérisé en ce que** le premier matériau (18, 19, 57) de protection à l'oxydation ou le deuxième matériau (18, 19, 57) de protection à l'oxydation est en or.

3. Procédé (21) selon la revendication précédente, **caractérisé en ce que** le premier matériau (18, 19, 57) de protection à l'oxydation et le deuxième matériau (18, 19, 57) de protection à l'oxydation sont formés en un même matériau.

4. Procédé (21) selon l'une des revendications précédentes, **caractérisé en ce que** ledit au moins un premier métal (13, 14, 15, 16, 35, 55) et ledit au moins un deuxième métal (15, 16, 13, 14, 35, 55) comportent chacun du nickel, du cuivre ou du nickel-cobalt.

5. Procédé (21) selon la revendication précédente, **caractérisé en ce que** ledit au moins un premier métal (13, 14, 15, 16, 35, 55) et ledit au moins un deuxième métal (15. 16, 13, 14, 35, 55) sont formés en un même matériau.

6. Procédé (21) selon l'une des revendications précédentes, **caractérisé en ce que** le procédé comporte, entre l'étape a) et l'étape b), une étape consistant à déposer une couche (13, 14, 33, 34) d'accrochage pour au moins une desdites première et une deuxième métallisations (9, 11, 49).

7. Procédé (21) selon la revendication précédente, **caractérisé en ce que** la couche (13, 14, 33, 34) d'accrochage comporte du molybdène et/ou du tungstène et/ou du titane et/ou du chrome.

8. Procédé (21) selon l'une des revendications précédentes, **caractérisé en ce que** la partie principale (2) et le couvercle (4, 44, 64) sont formés en céramique et/ou en métal.

9. Procédé (21) selon l'une des revendications précédentes, **caractérisé en ce que** l'étape g) est réalisée sous vide ou sous atmosphère contrôlée.

10. Procédé (21) selon l'une des revendications précédentes, **caractérisé en ce que** le système électro-micromécanique (5) est un résonateur diapason à quartz.

11. Procédé (21) selon l'une des revendications précédentes, **caractérisé en ce que** le matériau dont le point de fusion est inférieur à 250°C est de l'indium.

12. Procédé (21) selon l'une des revendications précédentes, **caractérisé en ce que** le matériau dont le point de fusion est inférieur à 250°C est de l'étain.

13. Procédé (21) selon l'une des revendications précédentes, **caractérisé en ce que**, avant l'étape g), le procédé comporte une étape consistant à disposer un matériau du type getter dans le dispositif d'encapsulage (3) afin d'y parfaire le vide.

14. Composant électronique (1) comportant un dispositif d'encapsulage (3) obtenu à partir du procédé (21) selon l'une des revendications 1 à 13 comportant un boîtier (7) comprenant une partie principale (2) formant une cavité (10) recevant un système électro-micromécanique (5), la partie principale (2) étant fermée hermétiquement par un couvercle (4, 44) à l'aide de moyens d'étanchéité (6) **caractérisé en ce que** les moyens d'étanchéité (6) comportent au moins un premier métal (13, 14, 15, 16, 35, 55) protégé par un premier intermétallique (19', 39', 59) formé par un premier matériau (18, 9, 57) de protection à l'oxydation avec un matériau (12, 52) dont le point de fusion est inférieur à 250°C, un deuxième intermétallique (20, 40) adjacent audit premier intermétallique (19', 39', 59) et formé par un deuxième matériau (18, 19, 57) de protection à l'oxydation, ledit matériau dont le point de fusion est inférieur à 250°C et au moins un deuxième métal (15, 16, 13, 14, 35, 55), et ledit au moins un deuxième métal (15, 16, 13, 14, 35, 55) pur afin de sceller hermétiquement le système électro-micromécanique (5) dans le dispositif d'encapsulage (3).

15. Composant électronique (1) selon la revendication précédente, **caractérisé en ce que** le premier matériau (18, 19, 57) de protection à l'oxydation ou le deuxième matériau (18, 19, 57) de protection à l'oxydation est en or.

16. Composant électronique (1) selon la revendication précédente, **caractérisé en ce que** le premier matériau (18, 19, 57) de protection à l'oxydation et le deuxième matériau (18, 19, 57) de protection à l'oxydation sont formés en un même matériau.

17. Composant électronique (1) selon l'une des revendications 14 à 16, **caractérisé en ce que** ledit au moins un premier métal (13, 14, 15, 16, 35, 55) et ledit au moins un deuxième métal (15, 16, 13, 14, 35, 55) comportent chacun du nickel, du cuivre ou du nickel-cobalt.

18. Composant électronique (1) selon la revendication précédente, **caractérisé en ce que** ledit au moins un premier métal (13, 14, 15, 16, 35, 55) et ledit au moins un deuxième métal (15, 16, 13, 14, 35, 55) sont formés en un même matériau.

19. Composant électronique (1) selon l'une des revendications 14 à 18, **caractérisé en ce que** les moyens d'étanchéité (6) comportent au moins une couche d'accrochage (13, 14, 33, 34) contre le boîtier (7).

20. Composant électronique (1) selon l'une des revendications 14 à 19, **caractérisé en ce que** ledit matériau dont le point de fusion est inférieur à 250°C est de l'indium.

21. Composant électronique (1) selon l'une des revendications 14 à 19, **caractérisé en ce que** ledit matériau dont le point de fusion est inférieur à 250°C est de l'étain.

22. Composant électronique (1) selon l'une des revendications 14 à 21, **caractérisé en ce que** le boîtier (7) est formé en céramique et/ou en métal.

23. Composant électronique (1) selon l'une des revendications 14 à 22, **caractérisé en ce que** la cavité (10) est sous vide ou sous atmosphère contrôlée.

24. Composant électronique (1) selon l'une des revendications 14 à 23, **caractérisé en ce qu'**un matériau du type getter est disposé dans le dispositif d'encapsulage (3) afin d'y parfaire le vide.

## Patentansprüche

1. Verfahren (21) zum Herstellen einer Vorrichtung (3) zum Einkapseln eines elektro-mikromechanischen Systems (5), **dadurch gekennzeichnet, dass** es die folgenden Schritte umfasst:
a) Bilden des elektro-mikromechanischen Systems (5), eines Hauptteils (2), der einen Hohlraum (10) bildet, und eines Deckels (4, 44);
b) Ablagern einer ersten und entsprechend einer zweiten Metallisierung (9, 11, 49) auf dem Hauptteil (2) und dem Deckel (4, 44), die jeweils mindestens ein erstes Metall (13, 14, 15, 16, 35, 55), das durch ein erstes Oxidationsschutzmaterial (18, 19, 57) geschützt ist, und mindestens ein zweites Metall (13, 14, 15, 16, 35, 55), das durch ein zweites Oxidationsschutzmaterial (18, 19, 57) geschützt ist, enthalten;
c) Ablagern einer Schicht (12, 52, 72) aus einem Material (12, 52), dessen Schmelzpunkt niedriger als 250 °C ist, ausschließlich entweder auf der ersten oder der zweiten Metallisierung (9, 11, 49);
d) teilweises Diffundieren des Materials (12, 52), dessen Schmelzpunkt niedriger als 250 °C ist, ausschließlich entweder in das erste oder in das zweite Oxidationsschutzmaterial (18, 19, 57), um entweder das erste oder entsprechend das zweite Oxidationsschutzmaterial (18, 19, 57) vollständig in ein Zwischenmetall (19) zu transformieren, das aus dem einen des ersten und des zweiten Oxidationsschutzmaterials (18, 19, 57) und aus dem Material, dessen Schmelzpunkt niedriger als 250 °C ist, gebildet ist, um eines des mindestens einen ersten und des mindestens einen zweiten Metalls (13, 14, 15, 16, 35, 55) zu schützen und um einen Teil (12', 52') zu belassen, in den das Material, dessen Schmelzpunkt niedriger als 250 °C ist, nicht diffundiert ist;
e) Montieren (25) des elektro-mikromechanischen Systems (5) in dem Hohlraum (10) des Hauptteils (2);
f) Zusammenfügen (27) des Teils (12', 52'), in den im Schritt d) das Material nicht diffundiert ist, dessen Schmelzpunkt niedriger als 250 °C ist, mit der anderen der ersten und der zweiten Metallisierung (9, 11, 49);
g) Vollständiges Diffundieren (29) des Teils (12', 52'), in den im Schritt d) das Material, dessen Schmelzpunkt niedriger als 250 °C ist, nicht diffundiert ist, in die andere der ersten und der zweiten Metallisierung (9, 11, 49), um den Teil (12', 52'), in den im Schritt d) das Material, dessen Schmelzpunkt niedriger als 250 °C ist, nicht diffundiert ist, vollständig in ein zweites Zwischenmetall (20) zu transformieren, das durch das andere des ersten und des zweiten Oxidationsschutzmaterials (18, 19, 57), das Material (12, 52), dessen Schmelzpunkt niedriger als 250 °C ist, und das andere des mindestens einen ersten und des mindestens einen zweiten Metalls (13, 14, 15, 16, 35, 55) gebildet ist, derart, dass das elektro-mikromechanische System (5) in die Einkapselungsvorrichtung (3) hermetisch eingeschlossen ist.

2. Verfahren (21) nach dem vorhergehenden Anspruch, **dadurch gekennzeichnet, dass** das erste Oxidationsschutzmaterial (18, 19, 57) oder das zweite Oxidationsschutzmaterial (18, 19, 57) Gold ist.

3. Verfahren (21) nach dem vorhergehenden Anspruch, **dadurch gekennzeichnet, dass** das erste Oxidationsschutzmaterial (18, 19, 57) und das zweite Oxidationsschutzmaterial (18, 19, 57) aus demselben Material gebildet sind.

4. Verfahren (21) nach einem der vorhergehenden Ansprüche, **dadurch gekennzeichnet, dass** das mindestens eine erste Metall (13, 14, 15, 16, 35, 55) und das mindestens eine zweite Metall (15, 16, 13, 14, 35, 55) jeweils Nickel, Kupfer oder Nickel-Kobalt enthalten.

5. Verfahren (21) nach dem vorhergehenden Anspruch, **dadurch gekennzeichnet, dass** das mindestens eine erste Metall (13, 14, 15, 16, 35, 55) und das mindestens eine zweite Metall (15, 16, 13, 14, 35, 55) aus demselben Material gebildet sind.

6. Verfahren (21) nach einem der vorhergehenden Ansprüche, **dadurch gekennzeichnet, dass** das Verfahren zwischen dem Schritt a) und dem Schritt b) einen Schritt umfasst, der darin besteht, eine Verankerungsschicht (13, 14, 33, 34) für die mindestens eine der ersten und der zweiten Metallisierungen (9, 11, 49) abzulagern.

7. Verfahren (21) nach dem vorhergehenden Anspruch, **dadurch gekennzeichnet, dass** die Verankerungsschicht (13, 14, 33, 34) Molybdän und/oder Wolfram und/oder Titan und/oder Chrom enthält.

8. Verfahren (21) nach einem der vorhergehenden Ansprüche, **dadurch gekennzeichnet, dass** das Hauptteil (2) und der Deckel (4, 44, 64) aus Keramik und/oder aus Metall gebildet sind.

9. Verfahren (21) nach einem der vorhergehenden Ansprüche, **dadurch gekennzeichnet, dass** der Schritt g) unter Vakuum oder in kontrollierter Atmosphäre ausgeführt wird.

10. Verfahren (21) nach einem der vorhergehenden Ansprüche, **dadurch gekennzeichnet, dass** das elektro-mikromechanische System (5) ein Quarz-Stimmgabelresonator ist.

11. Verfahren (21) nach einem der vorhergehenden Ansprüche, **dadurch gekennzeichnet, dass** das Material, dessen Schmelzpunkt niedriger als 250 °C ist, Indium ist.

12. Verfahren (21) nach einem der vorhergehenden Ansprüche, **dadurch gekennzeichnet, dass** das Material, dessen Schmelzpunkt niedriger als 250 °C ist, Zinn ist.

13. Verfahren (21) nach einem der vorhergehenden Ansprüche, **dadurch gekennzeichnet, dass** das Verfahren vor dem Schritt g) einen Schritt umfasst, der darin besteht, ein Material des Getter-Typs in der Einkapselungsvorrichtung (3) anzuordnen, um das Vakuum darin zu verbessern.

14. Elektronische Komponente (1), umfassend eine anhand des Verfahrens (21) nach einem der Ansprüche 1 bis 13 erhaltene Einkapselungsvorrichtung (3), die ein Gehäuse (7) aufweist, das einen Hauptteil (2) umfasst, der einen ein mikroelektromechanisches System (5) aufnehmenden Hohlraum (10) bildet, wobei der Hauptteil (2) durch einen Deckel (4, 44) mit Hilfe von Dichtungsmitteln (6) hermetisch verschlossen ist, **dadurch gekennzeichnet, dass** die Dichtungsmittel (6) umfassen: mindestens ein erstes Metall (13, 14, 15, 16, 35, 55), das durch ein erstes Zwischenmetall (19', 39', 59) geschützt ist, das durch ein erstes Oxidationsschutzmaterial (18, 19, 57) und ein Material (12, 52), dessen Schmelzpunkt niedriger als 250 °C ist, gebildet ist, ein zu dem ersten Zwischenmetall (19', 39', 59) benachbartes zweites Zwischenmetall (20, 40), das durch ein zweites Oxidationsschutzmaterial (18, 19, 57) gebildet ist, wobei der Schmelzpunkt des Materials niedriger als 250 °C ist, und mindestens ein zweites Metall (15, 16, 13, 14, 35, 55), und wobei das mindestens eine zweite Metall (15, 16, 13, 14, 35, 55) rein ist, um das elektro-mikromechanische System (5) in der Einkapselungsvorrichtung (3) hermetisch zu verschließen.

15. Elektronische Komponente (1) nach dem vorhergehenden Anspruch, **dadurch gekennzeichnet, dass** das erste Oxidationsschutzmaterial (18, 19, 57) oder das zweite Oxidationsschutzmaterial (18, 19, 57) Gold ist.

16. Elektronische Komponente (1) nach dem vorhergehenden Anspruch, **dadurch gekennzeichnet, dass** das erste Oxidationsschutzmaterial (18, 19, 57) und das zweite Oxidationsschutzmaterial (18, 19, 57) aus demselben Material gebildet sind.

17. Elektronische Komponente (1) nach einem der Ansprüche 14 bis 16, **dadurch gekennzeichnet, dass** das mindestens eine erste Metall (13, 14, 15, 16, 35, 55) und das mindestens eine zweite Metall (15, 16, 13, 14, 35, 55) jeweils Nickel, Kupfer oder Nickel-Kobalt enthalten.

18. Elektronische Komponente (1) nach dem vorhergehenden Anspruch, **dadurch gekennzeichnet, dass** das mindestens eine erste Metall (13, 14, 15, 16, 35, 55) und das mindestens eine zweite Metall (15, 16, 13, 14, 35, 55) aus demselben Material gebildet sind.

19. Elektronische Komponente (1) nach einem der Ansprüche 14 bis 18, **dadurch gekennzeichnet, dass** die Dichtungsmittel (6) mindestens eine Schicht (13, 14, 33, 34) für die Verankerung an dem Gehäuse (7) umfassen.

20. Elektronische Komponente (1) nach einem der Ansprüche 14 bis 19, **dadurch gekennzeichnet, dass** das Material, dessen Schmelzpunkt niedriger als 250 °C ist, Indium ist.

21. Elektronische Komponente (1) nach einem der Ansprüche 14 bis 19, **dadurch gekennzeichnet, dass** das Material, dessen Schmelzpunkt niedriger als 250 °C ist, Zinn ist.

22. Elektronische Komponente (1) nach einem der Ansprüche 14 bis 21, **dadurch gekennzeichnet, dass** das Gehäuse (7) aus Keramik und/oder aus Metall gebildet ist.

23. Elektronische Komponente (1) nach einem der Ansprüche 14 bis 22, **dadurch gekennzeichnet, dass** in dem Hohlraum (10) ein Vakuum herrscht oder eine kontrollierte Atmosphäre vorhanden ist.

24. Elektronische Komponente (1) nach einem der Ansprüche 14 bis 23, **dadurch gekennzeichnet, dass** in der Einkapselungsvorrichtung (3) ein Material des Getter-Typs angeordnet ist, um das Vakuum darin zu verbessern.

## Claims

1. Method (21) for fabricating an encapsulation device (3) for a micro-electromechanical system (5) **characterized in that** the method includes the following steps:
a) forming the micro-electromechanical system (5), a main portion (2) forming a cavity (10) and a cover (4, 44);
b) depositing, on the main portion (2) and the cover (4, 44) respectively, a first and a second metallization (9, 11, 49) respectively including at least a first metal (13, 14, 15, 16, 35, 55) protected by a first anti-oxidation material (18, 19, 57), and at least a second metal (13, 14, 15, 16, 35, 55) protected by a second anti-oxidation material (18, 19, 57);
c) depositing a layer (12, 52, 72) of a material (12, 52) whose melting point is lower than 250°C on solely one of the first and second metallizations (9, 11, 49);
d) partially diffusing the material (12, 52) whose melting point is lower than 250°C in solely one of the first and second anti-oxidation materials (18, 19, 57) in order to entirely transform said one of the first and second anti-oxidation materials (18, 19, 57) into an intermetallic compound (19) formed of said one of the first and second anti-oxidation materials (18, 19, 57) and of said material whose melting point is lower than 250°C in order to protect one of the at least one first and at least one second metals (13, 14, 15, 16, 35, 55), and to leave a non-diffused portion (12', 52') of the material whose melting point is lower than 250°C;
e) mounting (25) the micro-electromechanical system (5) in the cavity (10) of the main portion (2);
f) assembling (27) the portion (12', 52') of the material whose melting point is lower than 250°C which was not diffused in step d) against the other of the first and second metallizations (9, 11, 49);
g) totally diffusing (29) the portion (12', 52') of material whose melting point is lower than 250°C which was not diffused in step d) in the other of the first and second metallizations (9,11, 49) in order to entirely transform the portion (12', 52') of material whose melting point is lower than 250°C which was not diffused in step d) into a second intermetallic compound (20) formed by the other of the first and second anti-oxidation materials (18, 19, 57), the material (12, 52) whose melting point is lower than 250°C and the other of the at least one first and at least one second metals (13, 14, 15, 16, 35, 55), so as to hermetically close the micro-electromechanical system (5) inside the encapsulation device (3).

2. Method (21) according to the preceding claim, **characterized in that** the first anti-oxidation material (18, 19, 57) or the second anti-oxidation material (18, 19, 57) is made of gold.

3. Method (21) according to the preceding claim, **characterized in that** the first anti-oxidation material (18, 19, 57) and the second anti-oxidation material (18, 19, 57) are formed of the same material.

4. Method (21) according to any of the preceding claims, **characterized in that** said at least one first metal (13, 14, 15, 16, 35, 55) and said at least one second metal (15, 16, 13, 14, 35, 55) each include nickel, copper or nickel-cobalt.

5. Method (21) according to the preceding claim, **characterized in that** said at least one first metal (13, 14, 15, 16, 35, 55) and said at least one second metal (15, 16, 13, 14, 35, 55) are formed of the same material.

6. Method (21) according to any of the preceding claims, **characterized in that** the method includes, between step a) and step b), a step consisting in depositing an adhesion layer (13, 14, 33, 34) for at least one of said first and second metallizations (9, 11, 49).

7. Method (21) according to the preceding claim, **characterized in that** the adhesion layer (13, 14, 33, 34) includes molybdenum and/or tungsten and/or titanium and/or chromium.

8. Method (21) according to any of the preceding claims, **characterized in that** the main portion (2) and the cover (4, 44, 64) are formed of ceramic and/or metal.

9. Method (21) according to any of the preceding claims, **characterized in that** step g) is carried out in a vacuum or in a controlled atmosphere.

10. Method (21) according to any of the preceding claims, **characterized in that** the micro-electromechanical system (5) is a quartz tuning fork resonator.

11. Method (21) according to any of the preceding claims, **characterized in that** the material whose melting point is lower than 250°C is indium.

12. Method (21) according to any of the preceding claims, **characterized in that** the material whose melting point is lower than 250°C is tin.

13. Method (21) according to any of the preceding claims, **characterized in that**, prior to step g), the method includes a step consisting in arranging a getter material in the encapsulation device (3) to improve the vacuum therein.

14. Electronic component (1) including an encapsulation device (3) obtained from the method (21) according to any of claims 1 to 13, including a case (7) comprising a main portion (2) forming a cavity (10) receiving a micro-electromechanical system (5), the main portion (2) being hermetically closed by a cover (4, 44) with the aid of sealing means (6), **characterized in that** the sealing means (6) include at least one first metal (13, 14, 15, 16, 35, 55) protected by a first intermetallic compound (19', 39', 59) formed by a first anti-oxidation material (18, 19, 57) with a material (12, 52) whose melting point is lower than 250°C, a second intermetallic compound (20, 40) adjacent to said first intermetallic compound (19', 39', 59), and formed by a second anti-oxidation material (18, 19, 57), said material whose melting point is lower than 250°C and said at least one second pure metal (15, 16, 13, 14, 35, 55), and said at least second pure metal (15, 16, 13, 14, 35, 55) so as to hermetically seal the micro-electromechanical system (5) inside the encapsulation device (3).

15. Electronic component (1) according to the preceding claim, **characterized in that** the first anti-oxidation material (18, 19, 57) or the second anti-oxidation material (18, 19, 57) is made of gold.

16. Electronic component (1) according to the preceding claim, **characterized in that** the first anti-oxidation material (18, 19, 57) and the second anti-oxidation material (18, 19, 57) are formed of the same material.

17. Electronic component (1) according to any of claims 14 to 16, **characterized in that** said at least one first metal (13, 14, 15, 16, 35, 55) and said at least one second metal (15, 16, 13, 14, 35, 55) each include nickel, copper or nickel-cobalt.

18. Electronic component (1) according to the preceding claim, **characterized in that** said at least one first metal (13, 14, 15, 16, 35, 55) and said at least one second metal (15, 16, 13, 14, 35, 55) are formed of the same material.

19. Electronic component (1) according to any of claims 14 to 18, **characterized in that** the sealing means (6) include at least one adhesion layer (13, 14, 33, 34) for adhesion to the case (7)

20. Electronic component (1) according to any of claims 14 to 19, **characterized in that** said material whose melting point is lower than 250°C is indium.

21. Electronic component (1) according to any of claims 14 to 19, **characterized in that** said material whose melting point is lower than 250°C is tin.

22. Electronic component (1) according to any of claims 14 to 21, **characterized in that** the case (7) is formed of ceramic and/or metal.

23. Electronic component (1) according to any of claims 14 to 22, **characterized in that** the cavity (10) is in a vacuum or controlled atmosphere.

24. Electronic component (1) according to any of claims 14, to 23, **characterized in that** a getter material is arranged in the encapsulation device (3) in order to improve the vacuum therein.
